# EUROPEAN PATENT APPLICATION

(11) **EP 4 597 580 A1**
(43) Date of publication of application: **06.08.2025**
(21) Application number: 23910403.7
(22) Date of filing: 22.12.2023
(51) Int. Cl.: H01L 31/0224, G03F 7/20, H01L 31/054, H01L 31/20, H01L 31/0747, G03F 7/004

(54) **SOLAR CELL AND PREPARATION METHOD THEREFOR**

(30) Priority: 29.12.2022 CN 202211706196
(71) Applicant: Tongwei Solar (Chengdu) Co., Ltd., Chengdu, Sichuan 610299 (CN)
(72) Inventor: ZHANG, Qiaolin, Chengdu, Sichuan 610299 (CN); LUO, Xiaowei, Chengdu, Sichuan 610299 (CN); ZHU, Maoli, Chengdu, Sichuan 610299 (CN); LIAO, Jie, Chengdu, Sichuan 610299 (CN)
(74) Representative: Gill Jennings & Every LLP
(86) International application number: PCT/CN2023/141072
(87) International publication number: WO 2024/140477

(57) **Abstract**

Provided in the embodiments of the present application are a copper-grid-line solar cell and a preparation method therefor. When the copper-grid-line solar cell is prepared, a first exposure and a second exposure are sequentially performed on a photosensitive region of a negative photosensitive ink layer (700), wherein a laser line width and an energy density during the first exposure are both different from a laser line width and an energy density during the second exposure; development processing is then performed, so as to remove the part in a shading region and form gridline grooves; and electroplating processing is then performed, so as to form copper gridlines (800) in the gridline grooves.

## Description

This application claims priority to Chinese patent application No. 202211706196.7, entitled "SOLAR CELL WITH COPPER GRIDLINES AND PREPARATION METHOD THEREFOR" filed with the China National Intellectual Property Administration on December 29, 2022, the content of which is hereby incorporated by reference in its entirety.

### TECHNICAL FIELD

The present application relates to the field of new energy, particularly to a solar cell with copper gridlines and a preparation method thereof.

### BACKGROUND

Gridlines in solar cells are generally prepared by printing and sintering silver paste as a raw material, resulting in relatively high preparation costs of the gridlines. At present, in order to reduce the preparation cost of the gridlines, there is a method of using metal copper instead of metal silver as the raw material of the gridlines, which is known as copper interconnection technology. Moreover, since the strength of copper is higher than that of silver, replacing silver with copper to prepare the gridlines can not only reduce the preparation costs, but also allow to refine the gridlines as much as possible without significantly increasing the resistance, which reduces the shading area of the gridlines, thereby increasing the short-circuit current density of the solar cell, and thus improving the conversion efficiency of the cell.

In existing technologies for preparing copper gridlines, a photosensitive resist is generally coated on a cell sheet, and then is exposed to laser (i.e., laser printing) to form a gridline pattern, followed by electroplating to form the copper gridlines. However, the copper gridlines prepared by the above preparation method are prone to breakage, thus affecting the photoelectric conversion efficiency of the solar cell.

### SUMMARY

Embodiments of the present application aim to provide a solar cell with copper gridlines and a preparation method thereof. The copper gridlines of the prepared solar cell with copper gridlines are less prone to breakage, and are also beneficial to improving the photoelectric conversion efficiency of the solar cell.

According to a first aspect, an embodiment of the present application provides a method for preparing a solar cell with copper gridlines, which includes the following steps: coating negative photosensitive ink layers on front and back surfaces of a cell sheet respectively, the negative photosensitive ink layer being divided into a shading region corresponding to the copper gridlines and a photosensitive region not corresponding to the copper gridlines; subjecting the photosensitive region to a first exposure and a second exposure in sequence with laser, a laser linewidth and an energy density in the first exposure are different from a laser linewidth and an energy density in the second exposure; performing a development process to remove the negative photosensitive ink layer in the shading region and form gridline grooves; and performing an electroplating process to form copper gridlines in the gridline grooves.

In the above-described technical solution, the negative photosensitive ink is easily soluble in an alkali solution, but it can be denatured after being irradiated with light and becomes difficult to be dissolved in the alkali solution. Therefore, after the photosensitive region of the negative photosensitive ink is exposed to light (that is, selective exposure), the exposed photosensitive region cannot be removed during the subsequent development process, while the shading region that is not exposed to light can be removed, thereby forming gridline grooves. The copper gridlines can be prepared in the gridline grooves by electroplating. After that, a resist stripping and etching-back process is performed to remove the negative photosensitive ink in the photosensitive region, thereby forming a solar cell with copper gridlines.

Taking the front surface of the cell sheet as an example, it has been found by the applicant that, since the cell sheet generally has a textured surface structure (wherein the textured surface structure can enhance the absorbance of the cell sheet), the textured surface can cause a certain reflection during exposure to light, thereby increasing the area of the photosensitive region and decreasing the area of the shading region after the laser extends into the negative photosensitive ink layer. Subsequently, when forming the gridline grooves, the gridline grooves are relatively wide at the tops and relatively narrow at the bottoms, with cross sections in a shape of an inverted trapezoid. Consequently, the copper gridlines formed in such gridline grooves are also relatively wide at the tops and relatively narrow at the bottoms, with cross sections in the shape of the inverted trapezoid. This is the reason why the copper gridlines are very prone to breakage. Moreover, the shading area of the copper gridlines in such shape is relatively large, which is not conducive to improving the efficiency of the solar cell.

Based on this, the applicant further discovered that when the exposure is performed twice, and the laser linewidth and the energy density in each exposure are different, the shape of the gridline groove can be well regulated, which ensures the gridline groove to be in a shape that is relatively narrow at the top and relatively wide at the bottom, that is, the cross section of the gridline groove is in a shape of an upright trapezoid. As such, the copper gridlines formed in the gridline grooves are less prone to breakage, the shading area is not additionally enlarged, and the formed copper gridlines can reflect some sunlight onto the surface of the cell, which is conducive to increasing the short-circuit current of the solar cell, and thus improving the efficiency of the solar cell.

In connection with the first aspect, in an optional embodiment of the present application, the laser linewidth in the first exposure is greater than the laser linewidth in the second exposure, and the energy density in the first exposure is less than the energy density in the second exposure.

The applicant has also found that by setting a relatively wide laser linewidth and a relatively low energy density in the first exposure and a relatively narrow laser linewidth and a relatively high energy density in the second exposure, the above issues can be effectively addressed, so that the gridline grooves formed after development are in the shape that is relatively narrow at the top and relatively wide at the bottom, and the copper gridlines formed during subsequent electroplating are also in the shape that is relatively narrow at the top and relatively wide at the bottom. Such copper gridlines are less prone to breakage, and the shading area thereof is not additionally increased. Moreover, the formed copper gridlines can reflect some sunlight onto the surface of the cell, which is conducive to increasing the short-circuit current of the solar cell, and thus improving the efficiency of the solar cell.

In connection with the first aspect, in an optional embodiment of the present application, in the first exposure, the laser linewidth is in a range from 50 µm to 70 µm, and the energy density is in a range from 15 mJ/cm² to 35 mJ/cm²; and/or in the second exposure, the laser linewidth is in a range from 20 µm to 40 µm, and the energy density is in a range from 35 mJ/cm² to 65 mJ/cm².

In connection with the first aspect, in an optional embodiment of the present application, after forming the copper gridlines, a resist stripping and etching-back process is performed.

The resist stripping and etching-back process can further clean the cell sheet, and can remove the residual negative photosensitive ink on the surface of the cell sheet while retaining the copper gridlines.

In connection with the first aspect, in an optional embodiment of the present application, a thickness of the negative photosensitive ink layer is in a range from 10 µm to 15 µm.

In the above technical solution, by setting the thickness of the negative photosensitive ink within an appropriate range, it facilitates to the subsequent formation of the copper gridlines with a suitable size.

In connection with the first aspect, in an optional embodiment of the present application, during the first exposure and/or the second exposure, a temperature is in a range from 18°C to 28°C, and a humidity is in a range from 40% to 70%.

In connection with the first aspect, in an optional embodiment of the present application, a width of the copper gridline is in a range from 20 µm to 60 µm.

According to a second aspect, an embodiment of the present application provides a solar cell with copper gridlines prepared with the method for preparing the solar cell with copper gridlines in any one of the above-described embodiments.

In the above technical solutions, the copper gridlines of the solar cell with copper gridlines prepared with the above-described preparation method are less prone to breakage and can receive sunlight to the greatest extent, which is beneficial to improving the photoelectric conversion efficiency of the solar cell with copper gridlines.

In connection with the second aspect, in an optional embodiment of the present application, the solar cell with copper gridlines includes a cell sheet, wherein front and back surfaces of the cell sheet are provided with the copper gridlines, the copper gridlines form an ohmic contact with the cell sheet, and width of the copper gridlines increases as they approach the cell sheet.

In a possible embodiment, the cell sheet includes an N-type silicon wafer, wherein front and back surfaces of the N-type silicon wafer have textured surfaces; an intrinsic amorphous silicon layer, an N-type doped layer, a transparent conductive oxide (TCO ) layer, and a copper seed layer are stacked on the front surface of the N-type silicon wafer in sequence from near to far; the intrinsic amorphous silicon layer, a P-type doped layer, the TCO layer, and the copper seed layer are stacked on the back surface of the silicon wafer in sequence from near to far; and the copper gridlines form an electrical contact with the copper seed layer.

In connection with the second aspect, in an optional embodiment of the present application, a thickness of the copper seed layer is in a range from 90 nm to 200 nm.

In connection with the second aspect, in an optional embodiment of the present application, a thickness of the N-type silicon wafer is in a range from 120 µm to 200 µm; and/or a thickness of the N-type doped layer is in a range from 5 nm to 15 nm; and/or a thickness of the P-type doped layer is in a range from 5 nm to 15 nm; and/or a thickness of the intrinsic amorphous silicon layer is in a range from 3 nm to 9 nm.

In connection with the second aspect, in an optional embodiment of the present application, a thickness of the TCO layer is in a range from 90 nm to 110 nm.

### BRIEF DESCRIPTION OF THE DRAWINGS

To illustrate the technical solutions in the embodiments of the present application more clearly, the drawings used in the embodiments of the present application will be described briefly. It should be understood that the following drawings are merely for some embodiments of the present application and are not to be construed as limiting the scope. Other drawings can be derived according to these drawings by those of ordinary skill in the art without any creative effort.
FIG. 1 is a schematic structural view of a cell sheet provided with a negative photosensitive ink layer on the surfaces thereof according to an embodiment of the present application.
FIG. 2 is a schematic structural view of a solar cell with copper gridlines according to an embodiment of the present application.
FIG. 3 is a scanning electron microscopy image showing a gridline groove of the solar cell with copper gridlines according to Example 1 of the present application.
FIG. 4 is a scanning electron microscopy image showing a cross section of the copper gridline according to Example 1 of the present application.
FIG. 5 is a scanning electron microscopy image showing a gridline groove of the solar cell with copper gridlines according to Comparative Example 1 of the present application.
FIG. 6 is a scanning electron microscopy image showing a cross section of the copper gridline according to Comparative Example 1 of the present application.
FIG. 7 is a schematic diagram illustrating a principle in use of the copper gridlines according to Comparative Example 1 and Example 1 of the present application.

Reference signs: 100: N-type silicon wafer; 200: intrinsic amorphous silicon layer; 300: N-type doped layer; 400: P-type doped layer; 500: TCO layer; 600: copper seed layer; 700: negative photosensitive ink layer; 800: copper gridline.

### DETAILED DESCRIPTION

To make the objectives, technical solutions, and advantages of the embodiments of the present application more clear, the technical solutions in the embodiments of the present application will now be clearly and completely described below. Specific conditions that are not specified in the examples refer to conventional conditions or can be in accordance with conditions suggested by manufacturers. Reagents or instruments without indication of manufacturer are conventional products that are commercially available.

To save the manufacturing costs of solar cells, currently there is a technical solution of using copper gridlines instead of silver gridlines. When preparing copper gridlines in the prior art, a photosensitive resist is coated on a cell sheet, and then the photosensitive resist is sequentially subjected to an exposure process by using laser (i.e., laser printing) and a development process (i.e., removal of an unexposed photosensitive resist) to form a gridline pattern, followed by electroplating to form the copper gridlines. However, the applicant has found that since the textured surface structure on the surface of the silicon wafer can reflect the laser light, the gridline grooves formed after the exposure process and the development process in the prior art are typically in a shape that is "wide at the top and narrow at the bottom", that is, the width of the gridline groove becomes narrower as the gridline groove approaches to the cell sheet. As a result, the copper gridlines formed in the gridline grooves are prone to breakage, thus affecting the photoelectric conversion efficiency of the solar cell.

To address the technical issues in the prior art, in the embodiments of the present application, the cell sheet is subjected to twice exposure, and the laser linewidth and the energy density in each exposure are different, as such the shape of the gridline groove can be regulated. Specifically, in the present embodiment, the gridline groove can be regulated to be in the shape that is narrow at the top and wide at the bottom (that is, the cross section of the gridline groove is in a shape of an upright trapezoid). As a result, the copper gridlines formed in the gridline grooves are less prone to breakage, and the shading area is not additionally increased. Moreover, the formed copper gridlines can reflect some sunlight onto the surface of the cell, which is conducive to increasing the short-circuit current of the solar cell, and thus improving the efficiency of the solar cell.

Hereinafter, a solar cell with copper gridlines and a preparation method thereof according to embodiments of the present application will be specifically described.

The specific preparation steps of a solar cell with copper gridlines are as follows:

### S100: Pretreatment

In this step, usually a silicon wafer such as an N-type silicon wafer 100 or a P-type silicon wafer is cleaned and textured to remove impurities on the surfaces of the silicon wafer and form pyramid-shaped textured structures on the front and back surfaces of the silicon wafer, which is conductive to improving the absorbance of the silicon wafer, thereby improving the conversion efficiency of the solar cell with copper gridlines. In the present embodiment, the N-type silicon wafer 100 is selected for cleaning and texturing. Further, the thickness of the N-type silicon wafer 100 is generally in a range from 120 µm to 200 µm. Exemplarily, the thickness of the N-type silicon wafer 100 in the present embodiment is 168 µm.

During cleaning and texturing, an alkali solution, a SC1 cleaning liquid (i.e., a mixture of NaOH, hydrogen peroxide and water), a SC2 cleaning liquid (i.e., a mixture of hydrochloric acid, hydrogen peroxide and water), etc. are generally used for cleaning and texturing.

### S200: Formation of a cell sheet

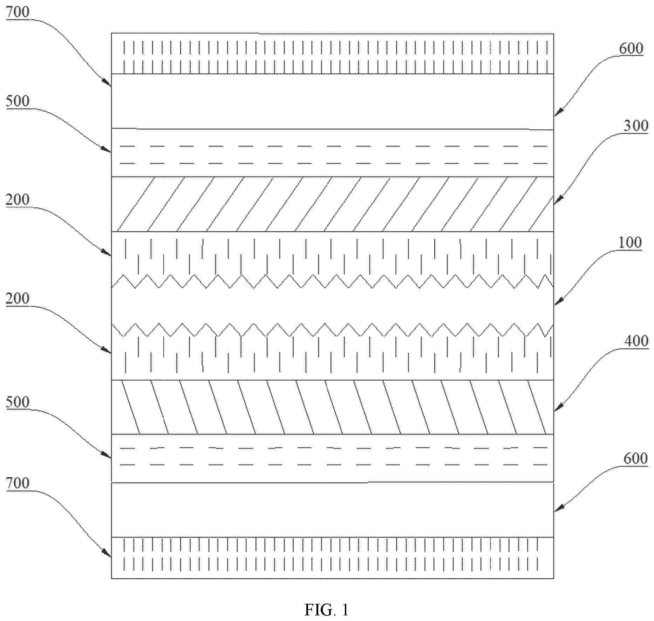

In this step, a plurality of layer structures is formed on the surfaces of the silicon wafer with textured surfaces to form the cell sheet, and each layer structure is generally deposited by physical vapor deposition (PVD) method, so that the thickness of each layer structure can be accurately controlled. The schematic structural view of the cell sheet is shown in FIG. 1.

Specifically, in the present embodiment, an intrinsic amorphous silicon layer 200, an N-type doped layer 300, a TCO layer 500, and a copper seed layer 600 are sequentially deposited on the front surface of the N-type silicon wafer 100; and the intrinsic amorphous silicon layer 200, a P-type doped layer 400, the TCO layer 500, and the copper seed layer 600 are sequentially deposited on the back surface of the N-type silicon wafer 100.

The thickness of the N-type doped layer 300 is in a range from 5 nm to 15 nm, the thickness of the p-type doped layer 400 is in a range from 5 nm to 15 nm, the thickness of the TCO layer 500 is in a range from 90 nm to 110 nm, and the thickness of the intrinsic amorphous silicon layer 200 is in a range from 3 nm to 9 nm. Exemplarily, the material of the TCO layer 500 in the present embodiment is indium tin oxide (ITO).

### S300: Formation of a negative photosensitive ink layer 700

In this step, negative photosensitive ink is coated onto the surface of the copper seed layer 600, and then is cured to form the negative photosensitive ink layer 700. The coating is generally performed by using a screen-printing machine, and the thickness of the negative photosensitive ink layer 700 formed after curing is generally in a range from 10 µm to 15 µm.

The applicant herein explains that: the negative photosensitive ink is an ink that changes its property when exposed to light. After the change, it changes from being soluble in an alkali solution to being insoluble in the alkali solution. The principle involves that: the negative photosensitive ink is composed of a photo-initiator, alkali-soluble macromolecules, and alkali-insoluble reactive monomers. Light irradiation can cause the photo-initiator to decompose and generate free radicals to trigger the polymerization reaction of the monomers. After polymerization, the molecular weight increases and a three-dimensional network structure is formed, which makes the negative photosensitive ink difficult to dissolve in the alkali solution. However, the unexposed portion does not undergo the specific reaction, and the alkali-soluble macromolecules can be dissolved. The negative photosensitive ink is commercially available, and its specific components will not be described in details herein.

It should be noted that, there is also positive photosensitive ink in the prior art, which changes its property when exposed to light and becomes easily soluble in the alkali solution. However, its costs are much higher than that of the negative photosensitive ink. In order to control the preparation costs of the solar cell with copper gridlines, almost no positive photosensitive ink is used.

### S400: Exposure to laser light

This step includes a first exposure and a second exposure in sequence, where the energy density in the first exposure is less than the energy density in the second exposure, and the laser linewidth in the first exposure is greater than the laser linewidth in the second exposure. Specifically, in the first exposure, the laser linewidth is in a range from 50 µm to 70 µm, and the energy density is in a range from 15 mJ/cm² to 35 mJ/cm²; in the second exposure, the laser linewidth is in a range from 20 µm to 40 µm, and the energy density is in a range from 35 mJ/cm² to 65 mJ/cm².

When the exposure is performed twice in step 400, by setting a relatively wide laser linewidth and a relatively low energy density in the first exposure and a relatively narrow laser linewidth and a relatively high energy density in the second exposure, the gridline grooves formed after development are in the shape that is relatively narrow at the top and relatively wide at the bottom, with the cross section in a shape of an upright trapezoid. The copper gridlines 800 formed during subsequent electroplating are also in the shape that is relatively narrow at the top and relatively wide at the bottom, with the cross section also in the shape of the upright trapezoid. Such copper gridlines 800 are less prone to breakage, and the shading area of the copper gridlines 800 is not additionally increased, which is conducive to improving the efficiency of the solar cell.

In addition, during the entire exposure treatment, the temperature is controlled to in a range from 18°C to 28°C, and the humidity is generally in a range from 40% to 70%.

### S500: Development process

In this step, the shading region is generally removed by using a weak alkali solution such as Na₂CO₃. After the shading region is removed, gridline grooves are formed in the negative photosensitive ink. Since the formed shading region is of an upright trapezoid structure that is narrow at the top and wide at the bottom, the formed gridline grooves are of the upright trapezoid structure that is narrow at the top and wide at the bottom. The applicant emphasizes herein that the gridline groove refers to a groove structure for providing a space for growing the copper gridlines, but cannot be understood as a groove structure on the surface of the copper gridlines.

The principle of removing the shading region by using the weak alkali solution is as follows. The negative photosensitive ink is composed of a photo-initiator, alkali-soluble macromolecules, and alkali-insoluble reactive monomers. After exposure to ultraviolet light, the initiator in the exposed region decomposes and generates free radicals to trigger the polymerization reaction. The portion of the negative photosensitive ink that underwent the polymerization forms a three-dimensional network structure due to the increased molecular weight, and shows reduced solubility in the weak alkali solution, thereby making it difficult to dissolve. However, the portion unexposed to ultraviolet light does not undergo cross-linking polymerization reaction, and the alkali-soluble hydrophilic group (i.e., -COOH, carboxyl group) reacts with the alkali solution, thus being dissolved.

### S600: Electroplating process

In this step, the cell sheet after the development process is placed in an electroplating solution and electroplated to form the copper gridlines 800 in the formed gridline grooves. Since the formed gridline grooves are of the upright trapezoid shape that is narrow at the top and wide at the bottom, the copper gridlines 800 formed in the gridline grooves after electroplating are also of the upright trapezoid shape that is narrow at the top and wide at the bottom. Such copper gridlines 800 are less prone to breakage, and the shading area of the copper gridlines 800 is not easily increased, which is conducive to improving the efficiency of the cell. In this step, the width of the formed copper gridlines 800 is generally in a range from 20 µm and 60 µm. In addition, in this step, an Sn protective layer can be electroplated on the surfaces of the copper gridlines 800 to protect the copper gridlines 800 from being damaged in the subsequent resist stripping and etching-back process, but also to effectively prevent the copper gridlines from being subsequently oxidated.

### S700: Resist stripping and etching-back process

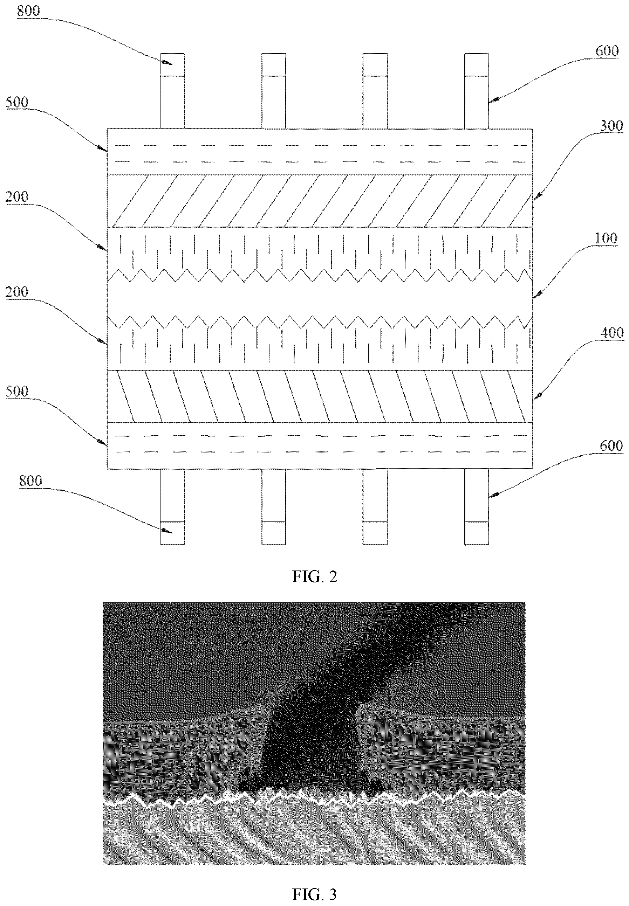

In this step, the electroplated cell sheet is further cleaned, so that the photosensitive region of the negative photosensitive ink can also be removed. Moreover, in this step, the region of the copper seed layer 600 not corresponding to the copper gridlines 800 is also removed. Only the region of the copper seed layer 600 corresponding to the copper gridlines 800 can be retained. This step generally adopts a strong alkali solution for treatment. The schematic structural view of the formed solar cell with copper gridlines is shown in FIG. 2.

The features and performance of the present application are further described in detail below with reference to examples.

### Example 1

This example provides a solar cell with copper gridlines, and the preparation method thereof is as follows:
(1) An N-type silicon wafer 100 with a thickness of 168 µm was selected for cleaning and texturing to form a pyramid textured surface on the surfaces of the N-type silicon wafer 100.
(2) By PVD method, 5 nm of an intrinsic amorphous silicon layer 200, 10 nm of an N-type doped layer 300, 100 nm of a TCO layer 500, and 150 nm of a copper seed layer 600 were sequentially deposited on the front surface of an N-type silicon wafer 100; and 5 nm of the intrinsic amorphous silicon layer 200, 10 nm of a P-type doped layer 400, 100 nm of the TCO layer 500, and 150 nm of the copper seed layer 600 were sequentially deposited on the back surface of the N-type silicon wafer 100, forming a cell sheet.
(3) A negative photosensitive ink layer 700 with a thickness of 12 µm was coated on each of the front and back surfaces of the cell.
(4) A region of the negative photosensitive ink layer 700 corresponding to the copper gridlines 800 was first exposed by using laser with an energy density of 15 mJ/cm² and a laser linewidth of 50 µm. After that, the same region of the negative photosensitive ink layer 700 was second exposed by using laser with an energy density of 35 mJ/cm² and a laser linewidth of 20 µm, forming a photosensitive region.
(5) The cell sheet coated with the negative photosensitive ink layer 700 in step (4) was treated with a Na₂CO₃ solution to remove the photosensitive region, forming gridline grooves, where the cross section of the gridline groove was in a shape of upright trapezoid that is narrow at the top and wide at the bottom.
(6) The cell sheet in step (5) was placed into an electroplating solution and was electroplated to form copper gridlines 800 in the gridline grooves. An Sn protective layer was coated onto the surface of the copper gridlines 800. The cross section of the formed copper gridlines 800 was in the shape of the upright trapezoid that is narrow at the top and wide at the bottom, with a width in a range from 20 µm and 60 µm.
(7) The cell sheet was placed into a strong alkali solution for a resist stripping and etching-back process to remove the remaining negative photosensitive ink layer 700 and the part of the copper seed layer 600 not corresponding to the copper gridlines 800.

### Example 2

This example provides a solar cell with copper gridlines. Compared to Example 1, the main differences in this preparation method thereof are as follows:

In step (4), the region of the negative photosensitive ink layer 700 corresponding to the copper gridlines 800 was first exposed by using laser with an energy density of 35 mJ/cm² and a laser linewidth of 70 µm. After that, the same region of the negative photosensitive ink layer 700 was second exposed by using laser with an energy density of 40 mJ/cm² and a laser linewidth of 40 µm, forming the photosensitive region.

### Example 3

This example provides a solar cell with copper gridlines. Compared to Example 1, the main differences in this preparation method thereof are as follows:

In step (4), the region of the negative photosensitive ink layer 700 corresponding to the copper gridlines 800 was first exposed by using laser with an energy density of 25 mJ/cm² and a laser linewidth of 60 µm. After that, the same region of the negative photosensitive ink layer 700 was second exposed by using laser with an energy density of 50 mJ/cm² and a laser linewidth of 30 µm, forming the photosensitive region.

### Comparative Example 1

This comparative example provides a solar cell with copper gridlines. Compared to Example 1, the main differences in this preparation method thereof are as follows:

In step (4), the region of the negative photosensitive ink layer 700 corresponding to the copper gridlines 800 was exposed by using laser with an energy density of 15 mJ/cm² and a laser linewidth of 50 µm, forming the photosensitive region.

### Application Example

Taking the solar cells with copper gridlines in Example 1 and Comparative Example 1 as examples, tests were conducted on the electrical performance and strength, respectively.

### Strength test

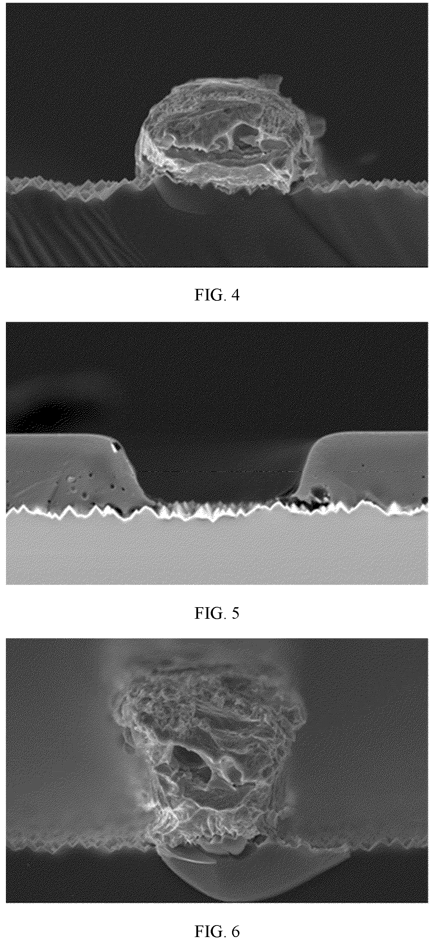

The gridline grooves and the copper gridlines of the solar cells with copper gridlines in Example 1 and Comparative Example 1 were observed by using a scanning electron microscope (SEM), respectively. The observation results of Example 1 are shown in FIGS. 3 to 4, while the observation results of Comparative Example 1 are shown in FIGS. 5 to 6.

As can be seen from FIGS. 3 and 4, in Example 1, the cross section of the copper gridline 800 is in a shape that is narrow at the top and wide at the bottom, so that the copper gridline 800 is less prone to breakage and no additional shading area is generated.

As can be seen from FIGS. 5 and 6, the gridline groove in Comparative Example 1 is narrow at the top and wide at the bottom, and the negative photosensitive ink remains at the bottom of the gridline groove. The cross section of the formed copper gridline 800 is also narrow at the top and wide at the bottom. In this case, the copper gridlines 800 are prone to breakage, and additional shading area can be generated.

The inventors further observed the gridline breakage ratio of the solar cells with copper gridlines. It was found that the gridline breakage ratio of the solar cells with copper gridlines in Example 1 is 13%, while the gridline breakage ratio of the solar cells with copper gridlines in Comparative Example 1 is 35%, which further demonstrates that the copper gridlines 800 in Comparative Example 1 are prone to breakage.

### Electrical performance test

When the electrical performance was tested by using a Halm tester, it was found that the short-circuit current of the solar cell with copper gridlines in Example 1 was increased by 60 mA compared with the short-circuit current of the solar cell with copper gridlines in Comparative Example 1, and the energy conversion efficiency was increased by 0.15%.

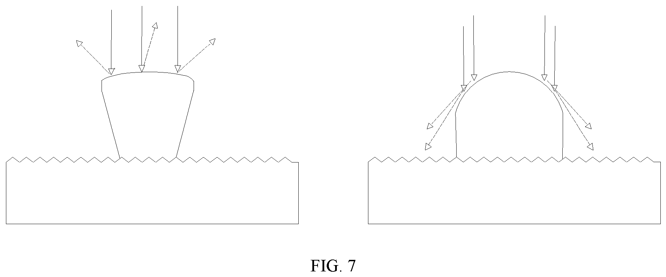

Moreover, it can be seen from the principle diagram in FIG. 7 that the copper gridline in Example 1 (shown on the right) exhibits a shape that is narrow at the top and wide at the bottom, similar to a dome shape. Therefore, some light can be reflected onto the surface of the cell, thereby increasing the short-circuit current and improving the energy conversion efficiency. In contrast, the copper gridline in Comparative Example 1 (shown on the left) cannot reflect light onto the surface of the cell, thus failing to increase the short-circuit current, and the shading area is additionally increased.

The above are merely examples of the present application, and are not intended to limit protection scope of the present application. For those skilled in the art, various modifications and changes can be made in the present application. Any modification, equivalent substitution, improvement, etc. made within the spirit and principles of this application shall fall within the protection scope of the present application.

## Claims

1. A method for preparing a solar cell with copper gridlines, comprising following steps:
coating negative photosensitive ink layers on front and back surfaces of a cell sheet respectively, the negative photosensitive ink layer being divided into a shading region corresponding to the copper gridlines and a photosensitive region not corresponding to the copper gridlines,
subjecting the photosensitive region to a first exposure and a second exposure in sequence with laser, a laser linewidth and an energy density in the first exposure are different from a laser linewidth and an energy density in the second exposure;
performing a development process to remove the negative photosensitive ink layer in the shading region and form gridline grooves; and
performing an electroplating process to form the copper gridlines in the gridline grooves.

2. The method for preparing the solar cell with copper gridlines according to claim 1, wherein the laser linewidth in the first exposure is greater than the laser linewidth in the second exposure, and the energy density in the first exposure is less than the energy density in the second exposure.

3. The method for preparing the solar cell with copper gridlines according to claim 1 or 2, wherein in the first exposure, the laser linewidth is in a range from 50 µm to 70 µm, and the energy density is in a range from 15 mJ/cm² to 35 mJ/cm².

4. The method for preparing the solar cell with copper gridlines according to any one of claims 1 to 3, wherein in the second exposure, the laser linewidth is in a range from 20 µm to 40 µm, and the energy density is in a range from 35 mJ/cm² to 65 mJ/cm².

5. The method for preparing the solar cell with copper gridlines according to any one of claims 1 to 4, wherein after forming the copper gridlines, a resist stripping and etching-back process is performed.

6. The method for preparing the solar cell with copper gridlines according to any one of claims 1 to 5, wherein a thickness of the negative photosensitive ink layer is in a range from 10 µm to 15 µm.

7. The method for preparing the solar cell with copper gridlines according to any one of claims 1 to 6, wherein during the first exposure, a temperature is in a range from 18°C to 28°C, and a humidity is in a range from 40% to 70%.

8. The method for preparing the solar cell with copper gridlines according to any one of claims 1 to 7, wherein during the second exposure, a temperature is in a range from 18°C to 28°C, and a humidity is in a range from 40% to 70%.

9. The method for preparing the solar cell with copper gridlines according to any one of claims 1 to 8, wherein a width of the copper gridline is in a range from 20 µm to 60 µm.

10. A solar cell with copper gridlines prepared with the method for preparing the solar cell with copper gridlines according to any one of claims 1 to 9.

11. The solar cell with copper gridlines according to claim 10, comprising a cell sheet, wherein front and back surfaces of the cell sheet are provided with the copper gridlines, the copper gridlines form an ohmic contact with the cell sheet, and width of the copper gridlines increases as they approach the cell sheet.

12. The solar cell with copper gridlines according to any one of claims 10 to 11, wherein the cell sheet comprises an N-type silicon wafer, front and back surfaces of the N-type silicon wafer have textured surfaces; an intrinsic amorphous silicon layer, an N-type doped layer, a TCO layer, and a copper seed layer are stacked on the front surface of the N-type silicon wafer in sequence from near to far; the intrinsic amorphous silicon layer, a P-type doped layer, the TCO layer, and the copper seed layer are stacked on the back surface of the silicon wafer in sequence from near to far; and the copper gridlines form an electrical contact with the copper seed layer.

13. The solar cell with copper gridlines according to claim 12, wherein a thickness of the copper seed layer is in a range from 90 nm to 200 nm.

14. The solar cell with copper gridlines according to claim 12 or 13, wherein a thickness of the N-type silicon wafer is in a range from 120 µm to 200 µm

15. The solar cell with copper gridlines according to any one of claims 12 to 14, wherein a thickness of the N-type doped layer is in a range from 5 nm to 15 nm.

16. The solar cell with copper gridlines according to any one of claims 12 to 15, wherein a thickness of the P-type doped layer is in a range from 5 nm to 15 nm.

17. The solar cell with copper gridlines according to any one of claims 12 to 16, wherein a thickness of the intrinsic amorphous silicon layer is in a range from 3 nm to 9 nm.

18. The solar cell with copper gridlines according to any one of claims 12 to 17, wherein a thickness of the TCO layer is in a range from 90 nm to 110 nm.
